# EUROPÄISCHE PATENTSCHRIFT

(11) **EP 3 592 696 B1**
(45) Veröffentlichungstag und Bekanntmachung des Hinweises auf die Patenterteilung: **05.10.2022**
(21) Anmeldenummer: 18712114.0
(22) Anmeldetag: 08.03.2018
(51) Int. Cl.: C25D 1/00, C25D 1/04, C25D 3/38, H01L 23/00, H01M 4/75, H05K 3/24, H05K 3/40, B82Y 40/00, H01M 4/04

(54) **ANORDNUNG UND VERFAHREN ZUM BEREITSTELLEN EINER VIELZAHL VON NANODRÄHTEN**
METHOD AND ARRANGEMENT FOR PROVIDING A PLURALITY OF NANOWIRES
PROCÉDÉ ET DISPOSITIF DE MISE À DISPOSITION D'UNE PLURALITÉ DE NANOFILS

(30) Priorität: 08.03.2017 DE 102017104906
(43) Veröffentlichungstag der Anmeldung: 15.01.2020
(73) Patentinhaber: NanoWired GmbH, 64579 Gernsheim (DE)
(72) Erfinder: BIRLEM, Olav, 68642 Bürstadt (DE); SCHLAAK, Helmut F., 64283 Darmstadt (DE); QUEDNAU, Sebastian, 64283 Darmstadt (DE); ROUSTAIE, Farough, 64283 Darmstadt (DE); DASSINGER, Florian, 64283 Darmstadt (DE); WICK, Konja, 64283 Darmstadt (DE)
(74) Vertreter: Keenway Patentanwälte Neumann Heine Taruttis
(86) Internationale Anmeldenummer: PCT/EP2018/055835
(87) Internationale Veröffentlichungsnummer: WO 2018/162681

(56) Entgegenhaltungen:
- CN-C- 1 155 980
- DE-A1-102008 015 333
- DE-A1-102010 053 782
- ROUSTAIE FAROUGH ET AL: "In situsynthesis of metallic nanowire arrays for ionization gauge electron sources", JOURNAL OF VACUUM SCIENCE & TECHNOLOGY B: MICROELECTRONICS AND NANOMETER STRUCTURES, AMERICAN INSTITUTE OF PHYSICS, 2 HUNTINGTON QUADRANGLE, MELVILLE, NY 11747, Bd. 34, Nr. 2, 12. Januar 2016 (2016-01-12), XP012203870, ISSN: 2166-2746, DOI: 10.1116/1.4939756 [gefunden am 1901-01-01]
- ARIANNA GAMBIRASI ET AL: "Direct electrodeposition of metal nanowires on electrode surface", ELECTROCHIMICA ACTA, ELSEVIER SCIENCE PUBLISHERS, BARKING, GB, Bd. 56, Nr. 24, 13. Juli 2011 (2011-07-13) , Seiten 8582-8588, XP028289239, ISSN: 0013-4686, DOI: 10.1016/J.ELECTACTA.2011.07.045 [gefunden am 2011-07-23]
- XING DAI ET AL: "Flexible Light-Emitting Diodes Based on Vertical Nitride Nanowires", NANO LETTERS, Bd. 15, Nr. 10, 9. September 2015 (2015-09-09), Seiten 6958-6964, XP055437780, ISSN: 1530-6984, DOI: 10.1021/acs.nanolett.5b02900

## Beschreibung

Die Erfindung betrifft eine Anordnung und ein Verfahren zum Bereitstellen einer Vielzahl von Nanodrähten.

Es sind verschiedenste Anordnungen und Verfahren bekannt, mit denen Nanodrähte auf verschiedenste Weisen erhalten werden können. Beispielsweise können Nanodrähte über galvanische Prozesse oder mittels Verfahren, die aus der Dünnschichttechnologie bekannt sind, erhalten werden. Vielen bekannten Verfahren ist gemein, dass diese komplexe Maschinen erfordern und insbesondere deshalb üblicherweise nur in Labors bzw. Reinräumen eingesetzt werden (können). Insbesondere mangelt es an einer industrie-tauglichen Vorrichtung, die die Nanodrähte direkt auf beliebigen Strukturen und Oberflächen (z.B. Chips, printed circuit board (PCB), Sensoren, Batterien etc.) erzeugen kann, ohne in die Strukturen einzugreifen oder diese zu zerstören.

Auch haben viele bekannte Anordnungen und Verfahren den Nachteil, dass die erhaltenen Nanodrähte stark in ihren Eigenschaften und insbesondere hinsichtlich ihrer Qualität variieren. Regelmäßig unterscheiden sich die Nanodrähte aus verschiedenen Wachstumsvorgängen auch dann zum Teil erheblich, wenn die gleichen oder dieselben Maschinen, Ausgangsmaterialien und/oder Rezepte verwendet werden. Oft hängt die Qualität von Nanodrähten insbesondere von dem Können des Nutzers einer entsprechenden Anordnung bzw. des Anwenders eines entsprechenden Verfahrens, von Umwelteinflüssen und/oder auch schlicht vom Zufall ab. Erschwert wird all dies dadurch, dass es sich bei Nanodrähten um Strukturen handelt, die teilweise auch mit einem Lichtmikroskop nicht zu visualisieren sind. Daher können aufwendige Untersuchungen notwendig sein, um die beschriebenen Eigenschaften (und insbesondere die Schwankungen in diesen) überhaupt feststellen zu können. Mit bekannten Verfahren und Anordnungen ist es insbesondere aufgrund der beschriebenen Qualitätsunterschiede oft nicht möglich, größere Flächen mit Nanodrähten zu bewachsen. So ist es wahrscheinlich, dass sich die Nanodrähte hinsichtlich ihrer Eigenschaften zwischen verschiedenen Bereichen einer größeren bewachsenen Fläche unterscheiden. Dies kann für viele Anwendungen nachteilig sein. Verfahren zur Herstellung von Nanodrähten sind z.B. bekannt aus Roustaie Farough et al.: "In-situ synthesis of metallic nanowire arrays for ionization gauge electron sources", Journal of Vacuum Science & Technology B;

A-rianna Gambirasi et al.: "Direct electrodeposition of metal nanowires on electrode surface", Elechtrocimica Acta, Elesvier Science Publishers, Barking, GB, Bd. 56, Nr. 24, 13. Juli 2011, Seiten 8582-858 8; DE 10 2008 015 333 A1 und Xing Dai et al.; "Flexible Light-Emitting Diodes Based on Vertical Nitride Nanowires", Nano Letters, Bd. 15, Nr. 10, 9. September 2015, Seiten 6958-6964

Hiervon ausgehend ist es Aufgabe der hier vorliegenden Erfindung, die im Zusammenhang mit dem Stand der Technik geschilderten technischen Probleme zu lösen bzw. zumindest zu verringern. Es soll insbesondere ein Verfahren vorgestellt werden, mit dem eine Vielzahl von Nanodrähten besonders großflächig und besonders zuverlässig bereitgestellt werden kann. Insbesondere soll ein Verfahren bereitgestellt werden, das einen industriellen Einsatz ohne zwingende Verwendung eines Reinraum-Labors ermöglicht. Außerdem soll eine entsprechende Anordnung vorgestellt werden.

Diese Aufgaben werden gelöst mit einem Verfahren und einer Anordnung gemäß den Merkmalen der unabhängigen Patentansprüche. Weitere vorteilhafte Ausgestaltungen des Verfahrens und der Anordnung sind in den jeweils abhängig formulierten Patentansprüchen angegeben. Die in den Patentansprüchen einzeln aufgeführten Merkmale sind in beliebiger, technologisch sinnvoller Weise miteinander kombinierbar und können durch erläuternde Sachverhalte aus der Beschreibung ergänzt werden, so lange diese Kombinationen und Varianten nicht über den Schutzumfang der Ansprüche hinausgehen.

Erfindungsgemäß wird ein Verfahren zum Bereitstellen einer Vielzahl von Nanodrähten vorgestellt, wobei das Verfahren die Verfahrensschritte nach Anspruch 1 umfasst.

Die angegebenen Verfahrensschritte werden vorzugsweise, aber nicht notwendigerweise, in der angegebenen Reihenfolge durchlaufen.

Unter einem Nanodraht (engl. "nanowire") wird hier jeder materielle Körper verstanden, der eine drahtähnliche Form und eine Größe im Bereich von wenigen Nanometern bis zu wenigen Mikrometern hat. Ein Nanodraht kann z.B. eine kreisförmige, ovale oder mehreckige Grundfläche aufweisen. Insbesondere kann ein Nanodraht eine hexagonale Grundfläche aufweisen. Vorzugsweise sind alle Nanodrähte aus dem gleichen Material gebildet.

Bevorzugt weisen die Nanodrähte eine Länge im Bereich von 100 nm [Nanometer] bis 100 µm [Mikrometer], insbesondere im Bereich von 500 nm bis 30 µm auf. Weiterhin weisen die Nanodrähte bevorzugt einen Durchmesser im Bereich von 10 nm bis 10 µm, insbesondere im Bereich von 30 nm bis 2 µm auf. Dabei bezieht sich der Begriff Durchmesser auf eine kreisförmige Grundfläche, wobei bei einer davon abweichenden Grundfläche eine vergleichbare Definition eines Durchmessers heranzuziehen ist. Es ist besonders bevorzugt, dass alle verwendeten Nanodrähte die gleiche Länge und den gleichen Durchmesser aufweisen.

Das beschriebene Verfahren ist für verschiedenste Materialien der Nanodrähte anwendbar. Als Material der Nanodrähte bevorzugt sind elektrisch leitende Materialien, insbesondere Metalle wie Kupfer, Silber, Gold, Nickel, Zinn und Platin. Aber auch nichtleitende Materialien wie Metalloxide sind bevorzugt.

Die Oberfläche, auf die die Nanodrähte gewachsen werden sollen, ist vorzugsweise elektrisch leitend ausgeführt. Sofern die Oberfläche Teil eines ansonsten elektrisch nicht leitenden Körpers (wie z.B. eines Substrats ist), kann die elektrische Leitfähigkeit z. B. durch eine Metallisierung erreicht werden. So kann z. B. ein nicht elektrisch leitendes Substrat mit einer dünnen Schicht Metall überzogen werden. Durch die Metallisierung kann insbesondere eine Elektrodenschicht erzeugt werden. Je nach Material der Oberfläche und/oder der Elektrodenschicht kann es sinnvoll sein, eine Haftschicht zwischen der Oberfläche und der Elektrodenschicht vorzusehen, die eine Haftung zwischen der Oberfläche und der Elektrodenschicht vermittelt.

Durch die elektrische Leitfähigkeit der Oberfläche kann diese als Elektrode für das galvanische Wachstum der Nanodrähte genutzt werden. Das Substrat kann insbesondere ein Siliziumsubstrat sein. Die Oberfläche kann insbesondere die Oberfläche eines Körpers sein, der mit elektrisch leitenden Strukturen versehen ist. Das kann insbesondere ein Siliziumchip oder ein sogenanntes printed circuit board (PCB) sein.

Die Verfahrensschritte a) bis c) können zunächst in der angegebenen Reihenfolge durchlaufen werden. Anschließend können die Nanodrähte von der Oberfläche entfernt und an anderer Stelle weiterverwendet werden. Dies kann z. B. wie weiter unten beschrieben durch Entfernen der Folie erfolgen. Alternativ ist es bevorzugt, dass die Nanodrähte durch Abkratzen oder Abstreifen (z. B. mittels eines Messers oder einer Klinge) von der Oberfläche entfernt werden. Auch ist es bevorzugt, dass die Nanodrähte durch Abtupfen (z. B. mittels eines Tuchs) von der Oberfläche entfernt werden. In all den genannten Fällen können die Nanodrähte (an einem anderen Ort als der Oberfläche, auf die sie gewachsen wurden) weiterverwendet werden.

Wurden die Nanodrähte wie beschrieben entfernt, können anschließend die Verfahrensschritte a) bis c) erneut durchgeführt werden (sowie ein gegebenenfalls erneutes Entfernen von neuen Nanodrähten).

Die Folie ist vorzugsweise mit einem Kunststoffmaterial, insbesondere mit einem Polymermaterial gebildet. Insbesondere ist es bevorzugt, dass die Folie derart mit der der Oberfläche verbunden wird, dass die Folie nicht verrutscht. Dies könnte die Qualität der gewachsenen Nanodrähte mindern.

Dass die Poren der Folie durchgehend ausgeführt sind, ist vorzugsweise derart realisiert, dass die Poren von einer Oberseite der Folie zu einer Unterseite der Folie durchgehende Kanäle ausbilden. Insbesondere ist es bevorzugt, dass die Poren zylinderförmig ausgeführt sind. Es ist aber auch möglich, dass die Poren als Kanäle mit gekrümmtem Verlauf ausgeführt sind. Eine Pore kann z.B. eine kreisförmige, ovale oder mehreckige Grundfläche aufweisen. Insbesondere kann eine Pore eine hexagonale Grundfläche aufweisen. Vorzugsweise sind die Poren gleichmäßig ausgeführt (d.h. die Poren unterscheiden sich vorzugsweise nicht hinsichtlich der Größe, Form, Anordnung und/oder Abstand zu benachbarten Poren).

Werden die Nanodrähte in Schritt c) gewachsen, so werden die Poren vorzugsweise (insbesondere vollständig) mit dem galvanisch abgeschiedenen Material gefüllt. Dadurch erhalten die Nanodrähte die Größe, Form und Anordnung der Poren. Durch Wahl der Folie bzw. der Poren darin können also die Eigenschaften der zu wachsenden Nanodrähte festgelegt bzw. beeinflusst werden. Die Folie kann daher auch als "Template", "Templatefolie" oder "Schablone" bezeichnet werden.

Bei dem Mittel zum Bereitstellen des Elektrolyten kann es sich um jede Vorrichtung handeln, die dazu eingerichtet und bestimmt ist, einen Elektrolyten zumindest an einer Ausgabestelle abzugeben. Vorzugsweise ist die Ausgabestelle flächig ausgeführt, wobei besonders bevorzugt ist, dass der Elektrolyt über eine Ausgabefläche gleichmäßig ausgegeben werden kann. Weiterhin ist es bevorzugt, dass das Mittel zum Bereitstellen des Elektrolyten die Folie vollständig überdeckt. Beispielsweise kann es sich bei dem Mittel zum Bereitstellen des Elektrolyten um einen Schwamm, ein Tuch, einen porösen festen Körper oder aber auch um eine Einspritzeinrichtung mit einer oder mehreren Düsen handeln. Das Mittel zum Bereitstellen des Elektrolyten ist bevorzugt derart ausgeführt, dass es zusätzlich eine Fixierung der Folie bewirken kann. Das kann insbesondere dadurch realisiert sein, dass das Mittel zum Bereitstellen des Elektrolyten flächig ausgeführt ist und zum Anpressen der Folie an die Oberfläche bestimmt und eingerichtet ist.

Gemäß der Schritte a) bis c) entsteht vorzugsweise ein Schichtaufbau aus zumindest den drei Schichten: Oberfläche, Folie und Mittel zum Bereitstellen des Elektrolyten (die in der hier genannten Reihenfolge angeordnet sind). Dieser Schichtaufbau kann in jeder beliebigen räumlichen Orientierung verwendet werden. Bevorzugt ist jedoch eine Orientierung, bei der die Oberfläche unten und das Mittel zum Bereitstellen des Elektrolyten oben angeordnet sind.

In Schritt c) erfolgt schließlich unter Verwendung des beschriebenen Schichtaufbaus das Wachstum der Nanodrähte. Dabei kann insbesondere über die folgenden Parameter die Qualität der Nanodrähte beeinflusst werden:
- eine angelegte Spannung,
- eine vorliegende Stromdichte,
- ein zeitlicher Verlauf der Stromdichte und/oder der Spannung,
- ein Druck des Elektrolyten auf die Oberfläche,
- eine Zusammensetzung des Elektrolyten,
- ein Anpressdruck der Folie auf die Oberfläche, insbesondere durch Anpressen des Mittels zum Bereitstellen des Elektrolyten,
- ein zeitlicher Verlauf des Anpressdruckes der Folie,
- eine bei dem Verfahren vorliegende Temperatur,
- ein bei dem Verfahren verwendeter zeitlicher Temperaturverlauf, und
- eine Strömung bzw. Bewegung des Elektrolyten.

Bei der angelegten Spannung handelt es ich um eine zwischen Elektroden für das galvanische Wachstum angelegte Spannung. Bei der Stromdichte handelt es sich um den auf die zu bewachsende Fläche bezogenen Strom (Strom / Rasenfläche).

Insbesondere können diese Parameter auch mit der Zeit verändert werden. Je nach verwendetem Material, Größe, Form, Dichte (d.h. mittlerem Abstand zwischen benachbarten Nanodrähten) und Anordnung der Nanodrähte können die optimalen Parameter variieren. Insbesondere eine zeitliche Veränderung der Stromdichte kann die Nanodrahtherstellung verbessern.

Bevorzugt wird das Verfahren für Kupfer bei Raumtemperatur durchgeführt. Die angelegte Spannung liegt bevorzugt zwischen 0,01 V und 2 V [Volt], insbesondere zwischen 0.1 V und 0,3 V. Als die Galvanik für Kupfer ist insbesondere eine Mischung aus CuSO₄ [Kupfersulfat], H₂SO₄ [Schwefelsäure] und H₂O [Wasser] sowie Zusätzen (Netzmittel, Einebner, Glanzzusatz) bevorzugt. Um unter diesen Bedingungen beispielsweise Nanodrähte aus Kupfer mit einem Durchmesser von 100 nm [Nanometer] und einer Länge von 10 µm [Mikrometer] zu erhalten, wird bevorzugt eine Stromdichte von 1,5 mA/cm² (7,5 mA / cm² bei Berücksichtigung der Porosität) [Milliampere pro Quadratzentimeter] (Gleichstrom) über eine Wachstumsdauer von 20 Minuten verwendet. Um beispielsweise Nanodrähte aus Kupfer mit einem Durchmesser von 1 µm [Mikrometer] und einer Länge von 10 µm [Mikrometer] zu erhalten, wird bevorzugt eine Stromdichte von 0,5-2 mA/cm² [Milliampere pro Quadratzentimeter] (Gleichstrom) über eine Wachstumsdauer von 40 Minuten verwendet. Insbesondere wird die Stromdichte bzw. Abscheidespannung während der Nanodrahtabscheidung variiert, insbesondere wird die Stromdichte/Spannung während der Abscheidung erhöht.

Vorzugsweise wird nach Abschluss des Wachstums der Nanodrähte in Schritt c) die Folie zumindest teilweise (besonders bevorzugt vollständig) entfernt. Damit können die Nanodrähte freigelegt werden, so dass sie zur weiteren Verwendung zur Verfügung stehen. Das Entfernen der Folie erfolgt vorzugsweise thermisch und/oder chemisch (z. B. mittels einer Lauge oder eines organischen Lösungsmittels) oder mittels Sauerstoffplasma.

In einer Ausführungsform ist es bevorzugt, dass zwei oder mehr Folien verwendet werden. Durch Aneinanderlegen mehrerer Folien können insbesondere Nanodrähte mit einer besonders großen Länge und/oder mit einer variablen, insbesondere hierarchischen, geometrischen Form erhalten werden. Ebenfalls ist durch das Aneinanderlegen mehrerer Folien ein Prozessschritt möglich, bei dem durch Abziehen der äußersten Folie alle Nanodrähte auf eine gemeinsame Länge, die sich insbesondere aus der Dicke der an der Oberfläche anliegenden Folie ergibt, gekürzt werden.

Mit dem beschriebenen Verfahren, insbesondere unter Verwendung der als bevorzugt beschriebenen Parameter, können Nanodrähte besonders hoher Qualität erhalten werden. Auch können diese über eine besonders große Oberfläche besonders gleichmäßig hinsichtlich Länge, Durchmesser, Struktur, Dichte (d.h. mittleren Abstands zwischen benachbarten Nanodrähten) und Materialzusammensetzung gewachsen werden. Auch ist das beschriebene Verfahren nicht auf den Einsatz in einem Labor beschränkt, da es insbesondere ohne Mikromontage-Handhabung auskommt. Verfahren, die beispielswiese mit Schwerionen-Beschuss arbeiten, sind auf eine Forschungseinrichtung beschränkt, da ein Ionenbeschleuniger eine feststehende Großanlage ist.

In einer bevorzugten Ausführungsform des Verfahrens wird eine Strukturierungsschicht zwischen der Oberfläche und der Folie bereitgestellt, wobei die Strukturierungsschicht mindestens eine Auslassung aufweist an einer Stelle der Oberfläche, an der die Nanodrähte auf die Oberfläche gewachsen werden sollen.

Mit der Strukturierungsschicht kann erreicht werden, dass die Nanodrähte nur in festlegbaren Bereichen der Oberfläche gewachsen werden. Diese Bereiche werden durch die mindestens eine Auslassung definiert. Vorzugsweise wird die mindestens eine Auslassung in der Strukturierungsschichtschicht durch eine fotolithographische Strukturierung erzeugt. Würde auf die Strukturierungsschichtschicht verzichtet, würden die Nanodrähte auf der gesamten Oberfläche erzeugt.

Bei der Strukturierungsschicht handelt es sich vorzugsweise um eine Schicht aus einem nicht elektrisch leitenden Material. Die Strukturierungsschichtschicht kann entweder vor Schritt a) auf die Oberfläche aufgebracht werden oder es kann eine Oberfläche mit bereits darauf befindlicher Strukturierungsschicht bereitgestellt werden. In dieser Ausführungsform erfolgt das Anlegen der Folie an die Oberfläche in Schritt a) durch Anlegen der Folie an die Strukturierungsschicht. Die Oberfläche und die Folie kommen insoweit jedenfalls außerhalb der mindestens einen Auslassung nicht unmittelbar sondern nur mittelbar (über die Strukturierungsschicht) in Kontakt.

Werden Nanodrähte auf der Oberfläche gewachsen und anschließend entfernt (insbesondere zur Verwendung an anderer Stelle), kann die Oberfläche zum Wachsen weiterer Nanodrähte wiederverwendet werden. In dem Fall kann die Strukturierungsschicht auf der Oberfläche belassen werden und eine (neue) Folie an die Strukturierungsschicht angelegt werden. Auch dies soll als ein Bereitstellen einer Strukturierungsschicht zwischen der Oberfläche und der Folie verstanden werden. Das bedeutet insbesondere, dass eine einmal mit einer Strukturierungsschicht versehene Oberfläche zu mehrmaligem Wachstum von Nanodrähten gemäß der Verfahrensschritte a) bis c) verwendet werden kann.

Die Strukturierungsschicht ist bevorzugt als eine Laminierschicht ausgebildet. Dabei meint Laminierschicht, dass die Strukturierungsschicht durch erweichen eines Kunststoffmaterials (insbesondere eines Polymermaterials) auf die Oberfläche aufgebracht wird. Die Strukturierungsschicht ist dabei bevorzugt mit Polymeren gebildet. Bevorzugt dient die Strukturierungsschicht auch dazu, die Position der Folie zu fixieren. Insbesondere in der alternativen Ausführungsform, in der die Strukturierungsschicht die Position der Folie nicht fixiert, kann die Strukturierungsschicht auch mit weiteren elektrisch isolierenden Materialien wie zum Beispiel Siliziumdioxid oder Siliziumnitrid gebildet sein.

Die Strukturierungsschicht weist bevorzugt eine Dicke von 200 nm [Nanometer] bis 10 mm [Millimeter] auf. Die Dicke der Strukturierungsschicht wird bevorzugt insbesondere in Abhängigkeit des Materials der Strukturierungsschicht gewählt. Ist die Strukturierungsschicht als eine Laminierschicht ausgeführt, kann die Folie durch Lamination auf der Oberfläche fixiert werden.

Durch die Wahl der Anzahl, Position, Größe und Gestalt der mindestens einen Auslassung in der Strukturierungsschicht kann gesteuert werden, in welchen Bereichen der Oberfläche die Nanodrähte gewachsen werden sollen. Dies ist insbesondere dadurch möglich, dass die Strukturierungsschicht nicht elektrisch leitend ausgeführt ist, so dass eine galvanische Abscheidung (und damit ein galvanisches Wachstum der Nanodrähte) auf das Material der Strukturierungsschicht nicht möglich ist. Dabei weist jede Auslassung vorzugsweise eine Ausdehnung auf, die groß ist im Vergleich zu einem mittleren Durchmesser der Nanodrähte und zu einem mittleren Abstand zwischen benachbarten Nanodrähten. Das bedeutet insbesondere, dass innerhalb jeder Auslassung jeweils eine Vielzahl von Nanodrähten gewachsen werden kann.

Es ist bevorzugt, dass die Folie derart auf die Strukturierungsschicht aufgelegt wird, dass die Folie zumindest teilweise die mindestens eine Auslassung in der Strukturierungsschicht überdeckt. Dadurch kann sichergestellt werden, dass zumindest in diesem Bereich der Überlappung ein Wachstum der Nanodrähte stattfinden kann. Weiterhin ist es bevorzugt, dass die Folie zumindest teilweise auch die Strukturierungsschicht in einem Bereich überdeckt, in dem die Strukturierungsschicht keine Auslassung aufweist. Dadurch kann sichergestellt werden, dass die Folie in ihrer Position fixiert ist. Die Fixierung kann auch durch das Mittel zum Bereitstellen des Elektrolyten sichergestellt werden.

Es ist bevorzugt, aber nicht notwendig, dass die Strukturierungsschicht die gesamte Oberfläche überdeckt und dass die Folie die gesamte Strukturierungsschicht überdeckt.

Als Alternative zum Laminierungsverfahren kann die Strukturierungsschicht durch einen Fotolack erzeugt werden, der durch einen Lithographie Prozess (Belichten mit einer Maske) mit der entsprechenden Strukturierung versehen wird und nach dem Entwickeln dann die Auslassungen freigibt auf denen dann die Nanodrähte gemäß Schritt a) bis c) gewachsen werden. In einer bevorzugten Variante dient der Fotolack aus als Laminierschicht.

In diesen Ausführungsformen entsteht vorzugsweise ein Schichtaufbau aus zumindest den vier Schichten: Oberfläche, Strukturierungsschicht, Folie und Mittel zum Bereitstellen des Elektrolyten (die in der hier genannten Reihenfolge angeordnet sind). Zusätzlich können auch die weiter oben beschriebene Elektrodenschicht (insbesondere bei einer elektrisch nicht leitenden Oberfläche) und gegebenenfalls auch eine Haftschicht in dem Schichtaufbau enthalten sein. So kann der Schichtaufbau insbesondere die folgenden sechs Schichten umfassen: Oberfläche, Haftschicht (die insbesondere elektrisch leitend sein kann), Elektrodenschicht (die elektrisch leitend ist), Strukturierungsschicht (die isolierende flächig ausgeführt sein kann), Folie und Mittel zum Bereitstellen des Elektrolyten. Die Elektrodenschicht stellt dann die Gegenelektrode für den galvanischen Prozess (Schritt c)) dar, die alternativ durch die Oberfläche selber gebildet wird.

In einer weiteren bevorzugten Ausführungsform des Verfahrens findet das Verfahren zumindest teilweise unter Erwärmung statt.

Die Erwärmung findet vorzugsweise in Schritt c) statt. Dabei werden bevorzugt die in der folgenden Tabelle für die verschiedenen Materialien der Nanodrähte angegebenen bevorzugten beziehungsweise besonders bevorzugten Temperaturen verwendet.

| Material der Nanodrähte | Bevorzugte Temperatur | besonders bevorzugte Temperatur |
|---|---|---|
| Kupfer | 13°...43° | 18°...28° |
| Silber | 50°...70° | 55°...65° |
| Platin | 50°...90° | 55°...85° |
| Gold | 50°...70° | 55°...65° |
| Nickel | 35°...55° | 40°...50° |
| Zinn | 13°...43° | 18°...28° |

Durch eine erhöhte Temperatur kann die Mobilität der Ionen im Elektrolyten erhöht werden. Damit kann das Wachstum der Nanodrähte begünstigt werden.

Der Elektrolyt wird dem Mittel zum Bereitstellen des Elektrolyten nach Bedarf zugeführt.

Der Elektrolyt wird dem Mittel zum Bereitstellen des Elektrolyten vorzugsweise über ein Rohr zugeführt. Der Bedarf an dem Elektrolyten ergibt sich insbesondere aus dem Verbrauch durch die galvanische Abscheidung. Steht am Ort des Wachstums der Nanodrähte zu wenig Elektrolyt zur Verfügung, so können sich Fehlstellen innerhalb der Nanodrähte bilden bzw. es können Bereiche entstehen, in denen keine Nanodrähte vorhanden sind. Weiterhin kann bei einem ungleichmäßig verteilten Elektrolyten, bei einer ungleichmäßigen Ionenkonzentration des Elektrolyten und/oder bei einer ungleichmäßigen Temperatur des Elektrolyten eine ungleichmäßige Wachstumsrate auftreten. Eine ungleichmäßige Wachstumsrate kann dazu führen, dass die Nanodrähte ungleichmäßig wachsen. Wird die zugeführte Menge des Elektrolyten also genau an den Verbrauch angepasst, können Nanodrähte besonders hoher Qualität und Homogenität erhalten werden. Insbesondere kann auch auf eine Abdichtung z. B. einer Elektrolysezelle (in der das Verfahren beispielsweise durchgeführt werden kann) verzichtet werden, wenn der Elektrolyt nicht derart überschüssig vorhanden ist, dass dieser unkontrolliert aus dem Mittel zum Bereitstellen des Elektrolyten austritt.

In einer weiteren bevorzugten Ausführungsform des Verfahrens wird das Mittel zum Bereitstellen des Elektrolyten zumindest zeitweise an die Folie gepresst.

Bevorzugt findet das Anpressen des Mittels zum Bereitstellen des Elektrolyten an die Folie während Schritt c) statt. Dies kann insbesondere während des gesamten Schritts c) erfolgen, bevorzugt jedoch nur in einer Anfangsphase des Nanodraht-Wachstums. Auch ein Anpressen bereits in Schritt c) ist bevorzugt. Durch das Anpressen des Mittels zum Bereitstellen des Elektrolyten an die Folie kann das Bereitstellen des Elektrolyten erleichtert werden. Beispielsweise kann der Elektrolyt aus einem Schwamm durch Pressen dieses Schwamms zum Austreten angeregt werden. Vorzugsweise ist zum Anpressen eine Feder vorgesehen, wobei die Kraft, mit der die Feder das Mittel zum Bereitstellen des Elektrolyten an die Folie presst, einstellbar ist. Auch können elastische oder plastische Elemente, motorische, hydraulische und/oder pneumatische Verstell-Einheiten oder Hebelmechanismen zum Erzeugen der Anpresskraft verwendet werden. Durch Einstellen der Kraft kann die ausgegebene Menge an Elektrolyt kontrolliert werden. Eine durch einen schwammartigen Körper abzugebende Menge eines Elektrolyten kann in Abhängigkeit von wenigstens einer Kenngröße eingestellt werden. Bei der wenigstens einen Kenngröße handelt es sich vorzugsweise um einen Stromverlauf, einen Spannungsverlauf, ein elektrisches Feld und/oder eine Temperatur handeln. Vorzugsweise wird eine pumpartige Bewegung des Schwamms erzeugt. Ein Pressen des Schwamms muss nicht zwingend homogensein. Es besteht auch die Möglichkeit, dass eine inhomogene Kraftverteilung der auf den Schwamm wirkenden Kraft vorgesehen ist. Hierdurch können Bereiche eingestellt werden in denen der Schwamm unterschiedliche Mengen eines Elektrolyten abgibt. Insbesondere kann eine konvexe Form des Schwamms mit einer daraus resultierenden von außen nach innen zunehmenden Anpresskraft vorteilhaft sein, um pulsierende Bewegungen zu realisieren. Weiterhin kann durch das Anpressen der Folie auf die Oberfläche beziehungsweise auf die Strukturierungsschicht sichergestellt werden, dass die Folie formschlüssig, ortsfest und frei von Lufteinschlüssen (zwischen der Folie und der Oberfläche beziehungsweise Strukturierungsschicht sowie in den Kanälen innerhalb der Folie) gehalten wird. Eine besonders gleichmäßige Elektrolytverteilung kann auch durch Bewegen des Mittels zum Bereitstellen des Elektrolyten während des Verfahrens sichergestellt werden. Die Bewegung kann dabei beispielsweise rotatorisch, horizontal und/oder vertikal erfolgen. Insbesondere ist es bevorzugt, dass das Mittel zum Bereitstellen des Elektrolyten mit einem zeitlich veränderlichen Druck an die Folie gepresst wird oder nach einer ersten Wachstumsphase von der Folie abgehoben wird und so ein optionales Verschließen von einzelnen Poren verhindert wird.

In einer weiteren bevorzugten Ausführungsform wird kontinuierlich frischer Elektrolyt dem Mittel zum Bereitstellen zugeführt und gleichzeitig überschüssiger Elektrolyt abgeführt. Dadurch wird eine Strömung des Elektrolyts erzwungen, die eine ausreichende Ionenzufuhr gewährleistet. Die Strömung kann auch durch Zirkulieren des Elektrolyts erreicht werden.

In einer weiteren bevorzugten Ausführungsform wird der Anpressdruck mit einem Messmittel überwacht und geregelt. Die Regelung kann insbesondere mit einem Regelglied erfolgen. Durch die Regelung kann insbesondere der Anpressdruck über die (vorzugsweise gesamte) Prozesszeit bestmöglich entsprechend vorgebbarer Werte eingestellt werden.

In einer weiteren bevorzugten Ausführungsform des Verfahrens ist das Mittel zum Bereitstellen des Elektrolyten schwammartig ausgeführt.

Unter einer schwammartigen Ausführung ist zu verstehen, dass das Mittel zum Bereitstellen des Elektrolyten dazu eingerichtet ist, den Elektrolyten zunächst aufzunehmen (insbesondere aufzusaugen), zu speichern und bei Bedarf (insbesondere unter Druck) wieder abzugeben. Als ein schwammartig ausgeführtes Mittel zum Bereitstellen des Elektrolyten sind bevorzugt:
- ein Schwamm (z. B. aus einem Schaumstoffmaterial, vorzugsweise einem Melaminschaum und/oder Teflonschaum),
- ein Tuch (z. B. aus Mikrofaser, Filterpapier, Baumwolle und/oder einem anderen Stoff) und
- ein poröser fester Körper (wie z. B. ein poröser Stein, ein poröses Glas und/oder ein Keramikschaum).

Besonders bevorzugt ist das Mittel zum Bereitstellen des Elektrolyten flexibel ausgeführt. Damit kann erreicht werden, dass das Mittel zum Bereitstellen des Elektrolyten den Elektrolyten unter Druck besonders gut abgeben kann. Auf diese Weise kann sichergestellt werden, dass jede Pore der Folie mit einer ausreichenden Menge des Elektrolyten versorgt wird. Auch kann ein solches Mittel zum Bereitstellen des Elektrolyten besonders gut an die Folie angepresst werden. Auch kann so eine Beschädigung der Folie verhindert werden.

In einer weiteren bevorzugten Ausführungsform des Verfahrens sind die durchgehenden Poren der Folie senkrecht zu der Oberfläche ausgeführt.

In dieser Ausführungsform können die Nanodrähte senkrecht zu der Oberfläche gewachsen werden. Dies ist für viele Anwendungen sinnvoll.

In einer weiteren bevorzugten Ausführungsform des Verfahrens wird zum galvanischen Wachsen der Vielzahl von Nanodrähten eine Spannung zwischen der zu bewachsenden Oberfläche und einer an dem Mittel zum Bereitstellen des Elektrolyten anliegenden Elektrode angelegt.

Als eine Elektrode kommt hier die elektrisch leitende Oberfläche (ggf. unter Berücksichtigung der weiter oben bereits beschriebenen Möglichkeit einer insbesondere durch Metallisierung erhaltbaren Elektrodenschicht) in Betracht. Die Elektrodenschicht ist bevorzugt durchgängig und geschlossen auf der Oberfläche ausgeprägt. Vorteilhafterweise werden für die Elektrodenschicht wahlweise Kupfer, Gold, Silber, Nickel, Platin, Zinn und/oder Aluminium verwendet. Ebenfalls kann Edelstahl verwendet werden. Wird die Oberfläche als eine Elektrode für das Wachstum der Nanodrähte verwendet, kann so ein homogenes elektrisches Feld über der gesamten Oberfläche erzeugt werden. Die zweite Elektrode ist vorzugsweise flächig ausgeführt, insbesondere derart, dass die zweite Elektrode das Mittel zum Bereitstellen des Elektrolyten zumindest teilweise (vorzugsweise vollständig) überdeckt. In dem Fall stellt die zweite Elektrode eine siebte Schicht in dem weiter oben beschriebenen Schichtaufbau dar: Oberfläche, Haftschicht, Elektrodenschicht, Strukturierungsschicht, Folie, Mittel zum Bereitstellen des Elektrolyten und zweite Elektrode. Die Oberfläche oder die Elektrodenschicht stellt dabei die erste Elektrode dar. Eine weitere Möglichkeit ist die Verwendung eines zusätzlichen Reservoirs oberhalb des Schwamms, damit immer ausreichend Elektrolyt zur Verfügung steht (Schwamm wird mit einem Sieb fest gedrückt). Die zweite Elektrode kann segmentiert ausgeführt werden um Inhomogenitäten der ersten Elektrodenschicht auszugleichen.

In einer weiteren bevorzugten Ausführungsform umfasst das Verfahren weiterhin die Verfahrensschritte:
d) Entfernen der Folie von der Oberfläche einschließlich der in der Folie eingeschlossenen Vielzahl der Nanodrähte, und
e) Aufbringen der Folie auf eine Zieloberfläche, wobei die in der Folie eingeschlossene Vielzahl der Nanodrähte mit der Zieloberfläche verbunden wird.

Die angegebenen Verfahrensschritte d) und e) werden vorzugsweise, aber nicht notwendigerweise, in der angegebenen Reihenfolge durchlaufen. Weiterhin ist es bevorzugt, die Verfahrensschritte d) und e) nach Durchlaufen der Verfahrensschritte a) bis c) (ebenfalls vorzugsweise in deren angegebener Reichenfolge) zu durchlaufen.

Wie bereits weiter oben beschrieben, kann es von Vorteil sein, die Nanodrähte zunächst auf einer Oberfläche zu wachsen und die Nanodrähte dann zur weiteren Verwendung auf eine andere Oberfläche (hier die Zieloberfläche) zu transferieren. Dazu bietet diese Ausführungsform eine bevorzugte Möglichkeit.

In einer weiteren bevorzugten Ausführungsform werden die gewachsenen Nanodrähte zumindest zeitweise durch Aufbringen einer Schutzschicht gegen Oxidieren und/oder Verkleben der Nanodrähte geschützt.

Die Schutzschicht kann insbesondere einen Schutzlack umfassen. Bevorzugt ist die Schutzschicht mit einem elektrisch nicht leitenden Material gebildet. Die Schutzschicht kann insbesondere für einen Transport und/oder eine Lagerung der Nanodrähte aufgebracht werden.

Die Schutzschicht kann insbesondere einen Schutz gegen weitere mechanische Bearbeitungsschritte, z.B. zersägen, darstellen.

In einer weiteren bevorzugten Ausführungsform des Verfahrens wird die Folie zumindest teilweise aufgelöst.

Vorzugsweise findet das Auflösen der Folie am Ende des Verfahrens statt, d.h. insbesondere nach Schritt c). Das Entfernen der Folie ist allgemein vorteilhaft, weil erst durch das Entfernen der Folie die Nanodrähte freigelegt werden. Bevorzugt wird die Folie vollständig aufgelöst. Damit können für eine spätere Verwendung der Nanodrähte ungewünschte Rückstände der Folie vermieden werden. Die Folie kann thermisch und/oder chemisch entfernt werden. Zum chemischen Entfernen ist es bevorzugt, die Folie einem (insbesondere organischen) Lösungsmittel, einer Lauge und/oder einem Plasma auszusetzen.

In einer weiteren bevorzugten Ausführungsform des Verfahrens weist die Oberfläche eine Mehrzahl von elektrisch leitenden Bereichen auf. Vor Schritt a) werden die folgenden Verfahrensschritte durchgeführt:
i) Aufbringen einer elektrisch leitenden Haftschicht auf die Oberfläche (insbesondere eines Substrates),
ii) Aufbringen einer elektrisch leitenden Elektrodenschicht auf die Oberfläche,
iii) Aufbringen einer elektrisch isolierenden Strukturierungsschicht auf die elektrisch leitende Elektrodenschicht, und
iv) Freilegen der elektrisch leitenden Bereiche der Oberfläche an den Stellen, an denen die Nanodrähte auf die elektrisch leitenden Bereiche gewachsen werden sollen, wobei eine elektrisch leitende Verbindung zwischen den elektrisch leitenden Bereichen und der elektrisch leitenden Elektrodenschicht erhalten bleibt.

Nach Schritt c) werden die folgenden Verfahrensschritte durchgeführt:
α) Entfernen der Folie,
β) Entfernen der Strukturierungsschicht,
γ) Entfernen der Elektrodenschicht und
Δ) Entfernen der elektrisch leitenden Haftschicht

Mit dieser Ausführungsform können Nanodrähte insbesondere auf Oberflächen mit elektrisch leitenden Strukturen besonders einfach gewachsen werden. Insbesondere kann es sich dabei um sogenannte printed circuit boards (PCB's) oder Silizium-Chips handeln. Diese weisen regelmäßig eine Oberfläche auf, die grundsätzlich elektrisch isolierend ist und auf der beispielsweise Kontaktpunkte und Leiterbahnen als elektrisch leitende Strukturen vorgesehen sind. Solche Kontaktpunkte sind ein Beispiel für die hier beschriebenen elektrisch leitenden Bereiche der zu bewachsenden Oberfläche. Bevorzugt ist, dass die elektrisch leitenden Bereiche der Oberfläche zunächst voneinander elektrisch isoliert sind. Das kann insbesondere durch eine Grundstrukturierungsschicht (die von der weiter vorne beschriebenen Strukturierungsschicht zu unterscheiden ist) erreicht werden, die elektrisch isolierend ausgeführt ist und die Auslassungen an den Stellen der elektrisch leitenden Bereiche aufweist. Um nach dem beschriebenen Verfahren Nanodrähte auf derartigen elektrisch leitenden Bereichen zu wachsen, ist es vorteilhaft, wenn die elektrisch leitenden Bereiche als Elektrode des galvanischen Wachstums verwendet werden können. Daher ist es bevorzugt, dass zumindest für die Dauer des beschriebenen Verfahrens eine elektrisch leitende Verbindung zwischen den zunächst voneinander getrennten elektrisch leitenden Bereichen der Oberfläche hergestellt wird. Das kann grundsätzlich dadurch erfolgen, dass jeder der elektrisch leitenden Bereiche einzeln kontaktiert wird, beispielsweise über eine Nadel. Insbesondere für eine Vielzahl von elektrisch leitenden Bereichen kann dies aber aufwendig sein. Die vorliegende Ausführungsform bietet eine besonders einfache Möglichkeit, auch eine große Zahl von elektrisch leitenden Bereichen miteinander zu verbinden und so deren Kontaktierung erheblich zu vereinfachen.

In Schritt i) wird eine Haftschicht aufgebracht. Das ist derart zu verstehen, dass eine Schicht aus einem elektrisch leitenden Material, insbesondere aus einem Metall, vorteilhafterweise Chrom, Titan oder Wolfram bzw. eine Legierung der beiden (TiW) beispielsweise mittels CVD (chemical vapor deposition) oder PVD (physical vapor deposition), über die gesamte Grundstrukturierungsschicht einschließlich der Auslassungen ausgebildet wird. Insbesondere ist es bevorzugt, dass die elektrisch leitende Haftschicht in die Auslassungen der Grundstrukturierungsschicht hinein ausgebildet wird und insbesondere auch an Kanten der Auslassungen ausgebildet wird. Damit ist gemeint, dass die elektrisch leitende Haftschicht derart durchgehend ausgebildet wird, dass eine elektrisch leitende Verbindung zwischen den elektrisch leitenden Bereichen, bevorzugt zwischen allen elektrisch leitenden Bereichen, hergestellt wird. Damit können die elektrisch leitenden Bereiche beispielsweise durch Kontaktieren der elektrisch leitenden Haftschicht kontaktiert werden. Bevorzugt erfolgt das Kontaktieren über die in Schritt ii) aufgebrachte Elektrodenschicht. Die elektrisch leitenden Bereiche können so gemeinsam als Elektrode für das galvanische Wachstum der Nanodrähte verwendet werden. Weiterhin sorgt die Haftschicht dafür, dass der anschließende Schichtaufbau mechanisch auf dem Substrat verankert wird und es auch unter Zug und Scherkräften, wie auch Temperaturwechseln nicht zu Ablösungen des Schichtaufbaus von der Oberfläche kommt.

In Schritt ii) wird eine elektrisch leitende Elektrodenschicht auf die Haftschicht aufgebracht. Das ist derart zu verstehen, dass eine Schicht aus einem elektrisch leitenden Material, insbesondere aus einem Metall, vorteilhafter weise Kupfer, Gold, Aluminium, Chrom, Titan, Nickel, Silber, Zinn über die gesamte Haftschicht einschließlich der Auslassungen der Grundstrukturierungsschicht ausgebildet wird. Insbesondere ist es bevorzugt, dass die elektrisch leitende Elektrodenschicht in die Auslassungen hinein ausgebildet wird und insbesondere auch an Kanten der Auslassungen ausgebildet wird. Damit ist gemeint, dass die elektrisch leitende Elektrodenschicht derart durchgehend ausgebildet wird, dass eine elektrisch leitende Verbindung zwischen den elektrisch leitenden Bereichen, bevorzugt zwischen allen elektrisch leitenden Bereichen, hergestellt wird. Damit können die elektrisch leitenden Bereiche insbesondere auch durch Kontaktieren der elektrisch leitenden Elektrodenschicht kontaktiert werden. Die elektrisch leitenden Bereiche können so gemeinsam als Elektrode für das galvanische Wachstum der Nanodrähte verwendet werden. Die elektrisch leitende Schicht muss nicht zwangsläufig als Elektrodenschicht dienen, sie kann auch nur zur Ankontaktierung der vorher isolierten Bereiche dienen. Die Ankontaktierung elektrisch voneinander isolierter Bereiche kann auch auf anderem Wege erfolge, z.B. durch Verbinden mittels Drahtbond-Verbindungen, gelöteten Drähten, leitfähigem Lack, etc.

In Schritt iii) wird die Strukturierungsschicht auf die Elektrodenschicht aufgebracht und die Auslassungen aus der Strukturierungsschicht werden in Schritt iv) ausgebildet. Dabei ist es bevorzugt, dass jedem der elektrisch leitenden Bereiche (Kontakte) genau eine Auslassung zugeordnet ist. Insbesondere ist es bevorzugt, dass die elektrisch leitenden Bereiche die jeweils entsprechende Auslassung vollständig überlappen. Die elektrisch leitenden Bereiche sind also bevorzugt größer als die jeweils entsprechende Auslassung der Strukturierungsschicht. Es ist auch möglich, dass ein elektrisch leitender Bereich mehreren Auslassungen zugeordnet ist, so dass also innerhalb dieses elektrisch leitenden Bereichs mehrere Auslassungen vorgesehen sind.

Würde das Wachstum der Nanodrähte nach Auftragen der elektrisch leitenden Elektrodenschicht durchgeführt, würden die Nanodrähte auf der elektrisch leitenden Elektrodenschicht wachsen. Durch das Aufbringen der elektrisch isolierenden Strukturierungsschicht in Schritt iii) kann dies unterdrückt werden. Bevorzugt wird die elektrisch isolierende Strukturierungsschicht in Schritt iii) derart auf die elektrisch leitende Elektrodenschicht aufgebracht, dass die elektrisch isolierende Strukturierungsschicht die elektrisch leitende Elektrodenschicht vollständig überdeckt. Auch bei der elektrisch isolierenden Strukturierungsschicht ist es bevorzugt, dass die Kanten der Auslassungen der Elektrodenschicht überdeckt werden. Damit ist gemeint, dass nach Aufbringen der elektrisch isolierenden Strukturierungsschicht vorzugsweise keine Bereiche der elektrisch leitenden Elektrodenschicht freiliegen. Dadurch ist ein Kontaktieren der elektrisch leitenden Elektrodenschicht zunächst nicht möglich.

In Schritt iv) werden die Stellen der elektrisch leitenden Bereiche der Elektrodenschicht freigelegt, an denen die Nanodrähte gewachsen werden sollen. Das bedeutet insbesondere, dass die elektrisch isolierende Strukturierungsschicht an diesen Stellen entfernt wird. Das kann insbesondere durch lithografische Verfahren und unter Verwendung von Chemikalien erfolgen, die selektiv nur die elektrisch isolierende Strukturierungsschicht entfernen.

Bevorzugt liegt nach Schritt iv) ein Zwischenprodukt (beispielhaft ein SiliziumChip mit darauf angeordnetem Schichtaufbau) vor, das folgendes Umfasst:
- eine Oberfläche mit einer Mehrzahl von elektrisch leitenden Bereichen,
- eine auf die Oberfläche aufgebrachte durchgängige Haftschicht die eine durchgängige elektrisch leitende Oberfläche als Haftvermittler bereitstellt,
- eine auf die Haftschicht aufgebrachte elektrisch leitende Elektrodenschicht, die als erste Elektrode dient (bzw. die die elektrisch leitenden Bereiche miteinander verbindet, die als Elektroden dienen),
- eine auf die elektrisch leitende Elektrodenschicht aufgebrachte elektrisch isolierende Strukturierungsschicht, die Auslassungen an den Stellen aufweist, an denen die Nanodrähte gewachsen werden sollen,
wobei die elektrisch leitende Haftschicht und die elektrisch leitende Elektrodenschicht derart ausgeführt sind, dass die elektrisch leitenden Bereiche der Oberfläche über die elektrisch leitende Schicht elektrisch leitend miteinander verbunden sind, und dass nur die Stellen der elektrisch leitenden Bereiche, an denen die Nanodrähte gewachsen werden sollen, freiliegen.

Auf die Haftschicht kann verzichtet werden. Das ist insbesondere dann der Fall, wenn beispielsweise ein PCB verwendet wird, dessen zu bewachsende Bereiche derart vorbereitet sind, dass die zu wachsenden Nanodrähte bereits eine ausreichende mechanische Haftung haben. Die (vorzugsweise) metallischen Nanodrähte können damit direkt auf der bereitgestellten Oberfläche des PCBs gewachsen werden. Die Schritte i) und Δ) entfallen dabei. Entsprechend ist die Ausführungsform des beschriebenen Verfahrens bevorzugt, in der die Oberfläche eine Mehrzahl von elektrisch leitenden Bereichen aufweist und in der vor Schritt a) die folgenden Verfahrensschritte durchgeführt werden:
ii) Aufbringen einer elektrisch leitenden Elektrodenschicht auf die Oberfläche,
iii) Aufbringen einer elektrisch isolierenden Strukturierungsschicht auf die elektrisch leitende Elektrodenschicht, und
iv) Freilegen der elektrisch leitenden Bereiche der Oberfläche an den Stellen, an denen die Nanodrähte auf die elektrisch leitenden Bereiche gewachsen werden
sollen, wobei eine elektrisch leitende Verbindung zwischen den elektrisch leitenden Bereichen und der elektrisch leitenden Elektrodenschicht erhalten bleibt,

Nach Schritt c) werden die folgenden Verfahrensschritte durchgeführt:
α) Entfernen der Folie,
β) Entfernen der Strukturierungsschicht, und
γ) Entfernen der Elektrodenschicht.

Die Beschreibung der Ausführungsform mit Haftschicht gilt hier entsprechend. In diesem Fall liegt nach Schritt iv) bevorzugt ein alternatives Zwischenprodukt (beispielhaft ein PCB mit darauf angeordnetem Schichtaufbau) vor, das folgendes Umfasst:
- eine Oberfläche mit einer Mehrzahl von elektrisch leitenden Bereichen,
- eine auf die Oberfläche aufgebrachte elektrisch leitende Elektrodenschicht, die als erste Elektrode dient (bzw. die die elektrisch leitenden Bereiche miteinander verbindet, die als Elektroden dienen),
- eine auf die elektrisch leitende Elektrodenschicht aufgebrachte elektrisch isolierende Strukturierungsschicht, die Auslassungen an den Stellen aufweist, an denen die Nanodrähte gewachsen werden sollen,
wobei die elektrisch leitende Elektrodenschicht derart ausgeführt ist, dass die elektrisch leitenden Bereiche der Oberfläche über die elektrisch leitende Schicht elektrisch leitend miteinander verbunden sind, und dass nur die Stellen der elektrisch leitenden Bereiche, an denen die Nanodrähte gewachsen werden sollen, freiliegen.

Für das Wachstum der Nanodrähte können die elektrisch leitenden Bereiche der Oberfläche oder der Elektrodenschicht als Elektrode verwendet werden. Weil die elektrisch leitenden Bereiche über die elektrisch leitende Schicht miteinander verbunden sind, kann dabei ein einzelnes Kontaktieren der elektrisch leitenden Elektrodenschicht ausreichen. Dazu ist es bevorzugt, dass die elektrisch isolierende Strukturierungsschicht an mindestens einer Stelle entfernt wird (oder an dieser Stelle gar nicht erst auf die elektrisch leitende Elektrodenschicht aufgebracht wird), so dass die elektrisch leitende Elektrodenschicht an dieser Stelle beispielsweise mit einer Nadel kontaktiert werden kann. Auch kann die elektrisch leitende Elektrodenschicht dadurch kontaktiert werden, dass die elektrisch isolierende Strukturierungsschicht mit einer Nadel durchstoßen wird.

Mit dem so durch die Schritte i) bis iv) (bzw. ii) bis iv)) erhaltenen Zwischenprodukt wird bevorzugt das Wachstum der Nanodrähte gemäß den Schritten a) bis c) des beschriebenen Verfahrens durchgeführt. Die Nanodrähte werden dabei in den gemäß Schritt iv) freigelegten Stellen der elektrisch leitenden Bereiche gewachsen. Nachdem die Drähte gewachsen sind, wir die Folie in Schritt α) entfernt. Das kann wie zuvor beschrieben thermisch und/oder chemisch erfolgen. Anschließend werden in den Schritten β) und γ) auch die elektrisch leitende Elektrodenschicht und die elektrisch isolierende Strukturierungsschicht entfernt. Das erfolgt bevorzugt unter Verwendung von Chemikalien, die insbesondere derart ausgewählt sind, dass diese selektiv nur die elektrisch leitende Elektrodenschicht bzw. die elektrisch isolierende Strukturierungsschicht entfernen, während insbesondere die elektrisch leitenden Bereiche der Oberfläche und die Nanodrähte von den Chemikalien nicht angegriffen werden. Alternativ können auch Chemikalien eingesetzt werden die mehrere Schichten gleichzeitig (also insbesondere die Haftschicht, die Elektrodenschicht und/oder die Strukturierungsschicht) entfernen. Das ist insbesondere dadurch möglich, dass vorteilhafterweise die Chemikalien nicht die metallischen Nanodrähte angreifen und/oder dadurch, dass die Schichtdicken so gewählt sind, dass das Auf- oder Ablösen der Schichten schneller erfolgt als ein Auflösen oder Angreifen der Nanodrähte (die insbesondere dicker ausgeführt sein können als die zu entfernenden Schichten). Auf diese besonders bevorzugte Weise kann mit einem Schritt der gesamte Schichtaufbau entfernt und die Nanodrähte freigelegt werden. In einer weiteren bevorzugten Ausführungsform des Verfahrens wird die Folie nach Durchführung der Schritte a) bis c) einschließlich der gewachsenen Nanodrähte entfernt. Anschließend werden die Schritte a) bis c) erneut durchgeführt. Die Schritte α) bis γ) (und gegebenenfalls Δ)) werden nach der erneuten Durchführung der Schritte a) bis c) durchgeführt.

Insbesondere durch Unebenheiten der elektrisch leitenden Bereiche kann es beim Wachstum der Nanodrähte vorkommen, dass die Nanodrähte ungleichmäßig hoch wachsen. Damit ist gemeint, dass die von der Oberfläche entfernten Enden der Nanodrähte nach Abschluss des Wachstums in unterschiedlichen Abständen von der Oberfläche angeordnet sind. Mit der vorliegenden Ausführungsform können Nanodrähte erhalten werden, die besonders gleichmäßig hoch gewachsen sind. Dazu kann insbesondere von einem der zuvor beschriebenen Zwischenprodukte ausgegangen werden. Gemäß den Schritten a) bis c) des beschriebenen Verfahrens werden darauf Nanodrähte gewachsen. Bei diesen Nanodrähten handelt es sich nicht um die Nanodrähte, die nach Abschluss des Verfahrens auf der Oberfläche verbleiben und auf deren Wachstum das beschriebene Verfahren gerichtet ist. Stattdessen handelt es sich um hilfsweise gewachsene Nanodrähte. Nach Wachstum der hilfsweise gewachsenen Nanodrähte wird die Folie einschließlich der hilfsweise gewachsenen Nanodrähte wieder entfernt. Das kann beispielsweise durch ein mechanisches Entfernen wie beispielswiese ein Abziehen der Folie erfolgen. Dabei können die hilfsweise gewachsenen Nanodrähte an der Grenzfläche zwischen der Folie und der Oberfläche abbrechen. Das ist insbesondere der Fall, wenn die hilfsweise gewachsenen Nanodrähte besonders dünn ausgeführt sind. Die hilfsweise gewachsenen Nanodrähte können insbesondere dünner sein als die Nanodrähte, die nach Abschluss des Verfahrens auf der Oberfläche verbleiben und auf deren Wachstum das Verfahren gerichtet ist. Durch Wachsen der hilfsweise gewachsenen Nanodrähte und das anschließende Entfernen der Folie einschließlich der hilfsweise gewachsenen Nanodrähte kann eine besonders ebene Fläche erhalten werden, auf der anschließend erneut mittelbar oder unmittelbar Nanodrähte gewachsen werden können. Auf diese Weise können Strukturen bereitgestellt werden, die hier als Bumps bezeichnet werden sollen. Damit ist gemeint, dass insbesondere die Auslassungen in der Grundstrukturierungsschicht mit dem Material der Nanodrähte derart gefüllt werden, dass die Bumps zusammen mit der obersten Schicht des Schichtaufbaus (also insbesondere mit der Strukturierungsschicht) eine durchgehende und ebene Fläche bilden. Vorteilhafter Weise können die Bumps somit zum Höhenausgleich eingesetzt werden und als Kontaktvermittler Verwendung finden. Auf diese Bumps können die Nanodrähte gewachsen werden, die nach Abschluss des Verfahrens auf der Oberfläche verbleiben und auf deren Wachstum das Verfahren gerichtet ist. Auf diese besonders ebene Fläche können diese Nanodrähte besonders gleichmäßig hoch wachsen. Die für diese Ausführungsform beschriebenen zusätzlichen Schritte können zusammenfassend als ein Glätten der Oberfläche beschrieben werden bzw. zum Erzeugen der Bumps verwendet werden.

In einer weiteren bevorzugten Ausführungsform des Verfahrens wird nach Abschluss des Wachstums der Vielzahl der Nanodrähte eine Oxidschicht auf den Nanodrähten zumindest teilweise entfernt.

Die nach dem beschriebenen Verfahren bereitgestellten Nanodrähte können insbesondere dazu verwendet werden, elektrische Leiter elektrisch und/oder mechanisch miteinander zu verbinden. Insbesondere können zwei Flächen miteinander verbunden werden. Dazu wird bevorzugt auf einer oder auf beiden der zu verbindenden Flächen jeweils eine Vielzahl von Nanodrähten bereitgestellt. Anschließend können die so erhaltenen Nanodrähte durch Aneinanderdrücken der Flächen miteinander in Kontakt gebracht werden. Dabei können die Nanodrähte eine elektrisch, mechanisch und/oder thermisch besonders stabile Verbindung zwischen den zu verbindenden Flächen ausbilden. Auf den Nanodrähten kann sich allerdings eine (natürliche) Oxidschicht bilden, die die mechanischen, elektrischen und/oder thermischen Eigenschaften der Verbindung verschlechtern kann. Durch Entfernen dieser Oxidschicht vor Ausbilden der Verbindung kann folglich die Qualität der Verbindung hinsichtlich der genannten Aspekte verbessert werden. Auch kann ein bei der Ausbildung der Verbindung notwendiger Druck durch Entfernen der Oxidschicht reduziert werden oder es kann ganz auf das Ausüben eines Drucks verzichtet werden. Das Entfernen der Oxidschicht findet vorzugsweise durch Anwendung eines Flußmittels (wie z.B. einer Säure, insbesondere einer reduzierenden Säure, wie Salzsäure (HCl) oder Ameisensäure (CH₂O₂) oder Zitronensäure (C₆H₈O₇) oder durch ein Plasma (z. B. ein Argon-Plasma) statt. Vorzugsweise enthält die verwendete Säure keine Sauerstoff-Atome (die durch chemische Reaktionen freigesetzt werden könnten, was zur erneuten Ausbildung der Oxidschicht beitragen könnte). Besonders bevorzugt trägt das Flußmittel auch zu der Ausbildung der Verbindung bei. Dies kann beispielsweise bei Akrylaten der Fall sein.

Die mit dem beschriebenen Verfahren erhaltenen Nanodrähte können insbesondere dazu verwendet werden, Kontaktflächen miteinander zu verbinden. Dazu wird bevorzugt auf einer oder auf allen an der Verbindung beteiligten Kontaktflächen jeweils eine Vielzahl von Nanodrähten nach dem beschriebenen Verfahren bereitgestellt. Durch Zueinanderführen der Kontaktflächen können die Nanodrähte miteinander in Kontakt gebracht werden, wobei die Nanodrähte miteinander verhaken und so eine Verbindung ausbilden. Das Entfernen der Oxidschicht erfolgt bevorzugt nach dem Zueinanderführen der Kontaktflächen. Alternativ oder zusätzlich erfolgt das Entfernen der Oxidschicht vor dem und/oder während des Zueinanderführen(s) der Kontaktflächen. Beispielsweise kann hierdurch eine oder mehrere LED (Light Emitting Diode) mit einem Substrat oder Träger verbunden werden.

Vor der Verwendung oder bei der Verwendung der hergestellten Nanodrähte können diese auch einer weiteren Behandlung unterzogen werden. So wird vorteilhafterweise durch eine Verwendung eines reduzierenden Mediums eine potentiell vorhandene Oxidschicht auf den Nanodrähten entfernt. Einer Entfernung einer Oxidschicht kann mittels Ameisensäure und/oder mittels Ultraschall erfolgen. Ein reduzierendes Medium kann auch eine Adhäsion (Verschmelzen der Nanodrähte zu einem im wesentlichen geschlossenen Gefüge) zusätzlich unterstützen, was zu einer Erhöhung der Festigkeit der Verbindung führen kann. Bei dem Medium kann es sich um ein flüssiges oder gasförmiges Medien handeln, welches die verbundenen Nanodrähte durchströmt und so die Oxidschicht entfernt und das Verschmelzen der Nanodrähte unterstützt. Vorzugsweise wird hierzu beispielsweise verdampfte Ameisensäure oder Formiergas verwendet.

Das Entfernen der Oxidschicht erfolgt bevorzugt im Vakuum (insbesondere in einer Vakuumkammer) oder unter einer Schutzgasatmosphäre, so dass ein erneutes Bilden einer Oxidschicht durch Luftsauerstoff unterbunden wird. Auch ist es bevorzugt, dass die Nanodrähte nach dem Entfernen der Oxidschicht und insbesondere bis zum Verbinden nicht mit Luft beziehungsweise mit Sauferstoff in Kontakt kommen. Auch das Verbinden der elektrischen Leiter erfolgt bevorzugt im Vakuum oder unter einer Schutzgasatmosphäre.

Gemäß einem weiteren Aspekt der Erfindung wird eine Anordnung zum Bereitstellen einer Vielzahl von Nanodrähten vorgestellt, die die Merkmale nach Anspruch 14 umfasst.

Die weiter oben beschriebenen besonderen Vorteile und Ausgestaltungsmerkmale des Verfahrens sind auf die beschriebene Anordnung anwendbar und übertragbar, und umgekehrt.

Als eine unterste Bezugsebene wird die Oberfläche beispielsweise eines Substrates verwendet. Die Oberfläche kann, wie zum Beispiel bei einem printed circuit board (PCB) oder bei einer äquivalenten Oberfläche mit leitenden Strukturen beispielsweise aus Kupfer, Gold oder Aluminium versehen sein. Insbesondere sofern die Oberfläche nicht hinreichend elektrisch leitend ist, wird bevorzugt eine durchgängige elektrisch leitende Schicht derart auf die Oberfläche aufgebracht, dass die elektrisch leitende Schicht als Elektrode für das beschriebene Verfahren verwendet werden kann. Vorzugsweise wird ein Haftvermittler (insbesondere eine Haftschicht) zwischen der Oberfläche und der elektrisch leitenden Elektrodenschicht vorgesehen. Vorzugsweise wird dabei eine durchgängige elektrisch leitende Haftschicht auf der Oberfläche erhalten.

Es kann ausreichend sein, lediglich eine Elektrode (beispielsweise eine Gegenelektrode) vorzusehen. Als zweite für das galvanische Wachstum der Nanodrähte benötigte Elektrode wird dann die Oberfläche verwendet, auf die die Nanodrähte gewachsen werden sollen. Ist auf die Oberfläche eine Metallisierung aufgebracht (beispielsweise weil die Oberfläche nicht, nicht durchgängig oder nicht hinreichend, elektrisch leitend ist), kann die Metallisierung (Elektrodenschicht) als die zweite Elektrode dienen. Alternativ ist es bevorzugt, dass zwei Elektroden vorgesehen sind, zwischen denen die zum Wachstum der Nanodrähte benötigte Spannung angelegt werden kann.

In einer bevorzugten Ausführungsform umfasst die Anordnung weiterhin eine zwischen der Oberfläche bzw. Elektrodenschicht und der Folie angeordnete Strukturierungsschicht, wobei die Strukturierungsschicht mindestens eine Auslassung aufweist an einer Stelle der Oberfläche, an der die Nanodrähte auf die Oberfläche gewachsen werden sollen.

In einer weiteren bevorzugten Ausführungsform umfasst die Anordnung weiterhin eine Vorrichtung zum Bereitstellen der Strukturierungsschicht auf der Oberfläche, auf die die Nanodrähte gewachsen werden sollen.

Bei der Vorrichtung zum Bereitstellen der Strukturierungsschicht handelt es sich vorzugsweise um eine Laminiervorrichtung, eine Vakuumbeschichtungsanlage, eine Lackschleuder oder eine Sprüheinrichtung oder eine Tauchbeschichtungsanlage. Mit dieser kann vorzugsweise eine Lackschicht als die Strukturierungsschicht auf die Oberfläche aufgebracht werden.

In einer weiteren bevorzugten Ausführungsform umfasst die Anordnung weiterhin eine Referenzelektrode.

Die Referenzelektrode ist vorzugsweise innerhalb des Mittels zum Bereitstellen des Elektrolyten und vorteilhafterweise möglichst nah an der Elektrodenschicht angeordnet. Vorzugsweise ist die Referenzelektrode derart über eine Messelektronik mit mindestens einer der für die Elektrolyse vorgesehenen Elektroden verbunden, dass eine elektrochemische Potentialdifferenz zwischen der Referenzelektrode und der für die Elektrolyse vorgesehenen Elektrode einstellbar ist. Dies kann insbesondere unter Verwendung eines Messgeräts, insbesondere eines solchen für eine elektrische Spannung, erfolgen. Der erhaltene Wert ist ein Maß für die elektrochemische Aktivität an der Elektrodenoberfläche. Über den erhaltenen Wert kann insbesondere erkannt werden, wie viel Elektrolyt dem Mittel zum Bereitstellen des Elektrolyten zugeführt werden muss.

Die Erfindung und das technische Umfeld werden nachfolgend anhand der Figuren näher erläutert. Die Figuren zeigen besonders bevorzugte Ausführungsbeispiele, auf die die Erfindung jedoch nicht begrenzt ist. Insbesondere ist darauf hinzuweisen, dass die Figuren und insbesondere die dargestellten Größenverhältnisse nur schematisch sind. Es zeigen schematisch:
- Fig. 1:: eine Querschnittsansicht einer Anordnung wie hier beschrieben, und
- Fig. 2:: eine Schnittansicht von oben durch die Strukturierungsschicht der Anordnung aus Fig. 1,
- Fig. 3a bis 3i:: neun schematische Darstellungen eines Verfahrens zum Bereitstellen einer Vielzahl von Nanodrähten

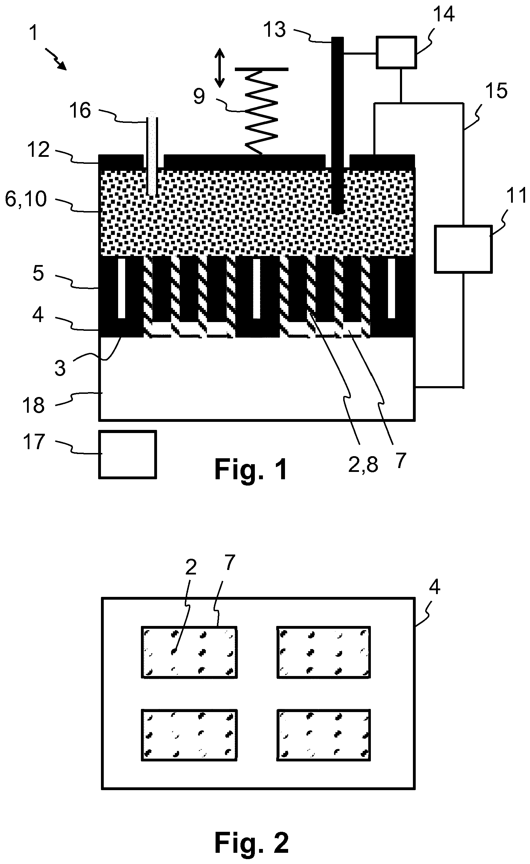

Fig. 1 zeigt eine Anordnung 1 zum Bereitstellen einer Vielzahl von Nanodrähten 2. Die Anordnung 1 umfasst einen Körper 18 mit einer Oberfläche 3, auf die die Nanodrähte 2 gewachsen werden sollen. Auf die Oberfläche 3 ist eine Strukturierungsschicht 4 aufgelegt, wobei die Strukturierungsschicht 4 mehrere Auslassungen 7 aufweist (in dieser Darstellung sind zwei Auslassungen 7 zu erkennen). An den Stellen der Auslassungen 7 sollen die Nanodrähte 2 auf die Oberfläche 3 gewachsen werden. Weiterhin ist eine auf die Strukturierungsschicht 4 aufgelegte Folie 5 vorgesehen. Die Folie 5 weist eine Vielzahl von durchgehenden Poren 8 auf, in denen die Nanodrähte 2 gewachsen werden können. Nanodrähte 2 wachsen lediglich in den Poren 8 an den Stellen der Auslassungen 7 der Strukturierungsschicht 4. An den anderen Stellen ist ein galvanisches Wachsen der Nanodrähte 2 unterbunden. Auf die Folie 5 ist ein Schwamm 10 als ein Mittel zum Bereitstellen eines Elektrolyten 6 aufgelegt. Weiterhin ist eine Elektrode 12 vorgesehen, die an dem Schwamm 10 anliegt. Zwischen der Elektrode 12 und der Oberfläche 3, die elektrisch leitend ist, kann mittels einer Spannungsquelle 11 und über Kabel 15 eine Spannung angelegt werden. Mit dieser Spannung kann das galvanische Wachsen der Vielzahl von Nanodrähten 2 realisiert werden. Weiterhin ist eine Referenzelektrode 13 vorgesehen. Zwischen der Referenzelektrode 13 und der Elektrode 12 kann mit einem Messgerät 14 eine elektrischer Potentialdifferenz gemessen werden. Über ein Rohr 16 kann der Elektrolyt dem Schwamm 10 zugeführt werden. Der Schwamm 10 kann mittels einer Feder 9 (hydraulisch, elektromotorisch, pneumatisch) an die Folie 5 gepresst werden. Dabei ist die Feder 9 derart befestigt, dass eine auf den Schwamm 10 einwirkende Kraft einstellbar ist. Dies ist durch den Doppelpfeil angedeutet. Weiterhin eingezeichnet ist eine Heizung 17, mittels derer das Wachstum der Nanodrähte 2 (vollständig oder nur zeitweise) unter Erwärmung stattfinden kann und/oder mittels derer die Folie 5 (zumindest teilweise) aufgelöst werden kann.

Fig. 2 zeigt die Strukturierungsschicht 4 aus Fig. 1 als eine Schnittansicht von oben. Zu erkennen sind hier die Auslassungen 7 mit den Nanodrähten 2, die nur an den Stellen der Auslassungen 7 wachsen können. Die Nanodrähte 2 haben einen kreisförmigen Querschnitt.

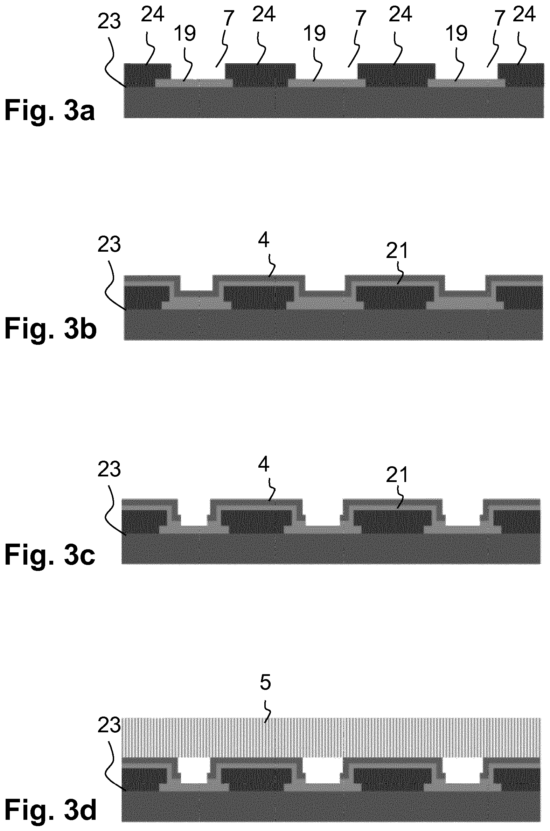

Die Fig. 3a bis 3i zeigen neun schematische Darstellungen eines Verfahrens zum Bereitstellen einer Vielzahl von Nanodrähten. In Fig. 3a ist eine Grundoberfläche 23 mit drei elektrisch leitenden Bereichen 19 gezeigt. Auf die Grundoberfläche 23 ist eine Grundstrukturierungsschicht 24 (zum Beispiel ein Lötstopplack) aufgebracht, die für jede der elektrisch leitenden Bereiche 19 jeweils eine Auslassung 7 aufweist (zum Beispiel Kontakt). Die Grundoberfläche 23 und die Grundstrukturierungsschicht 24 bilden gemeinsam eine Oberfläche 3 im Sinne der Figur 1.

In Fig. 3b ist auf die Grundstrukturierungsschicht 24 eine elektrisch leitende Elektrodenschicht 21 und auf diese eine elektrisch isolierende Strukturierungsschicht 4 aufgebracht.

In Fig. 3c sind die Stellen der elektrisch leitenden Bereiche 19 freigelegt und alle elektrisch leitenden Bereiche 19 (die insbesondere Kontakte bilden können) miteinander verbunden, an denen Nanodrähte 2 gewachsen werden sollen.

In Fig. 3d ist eine Folie 5 auf die Strukturierungsschicht 4 aufgelegt, wobei dieFolie 5 eine Vielzahl von durchgehenden Poren 8 aufweist, in denen hilfsweise gewachsene Nanodrähte 22 gewachsen werden können.

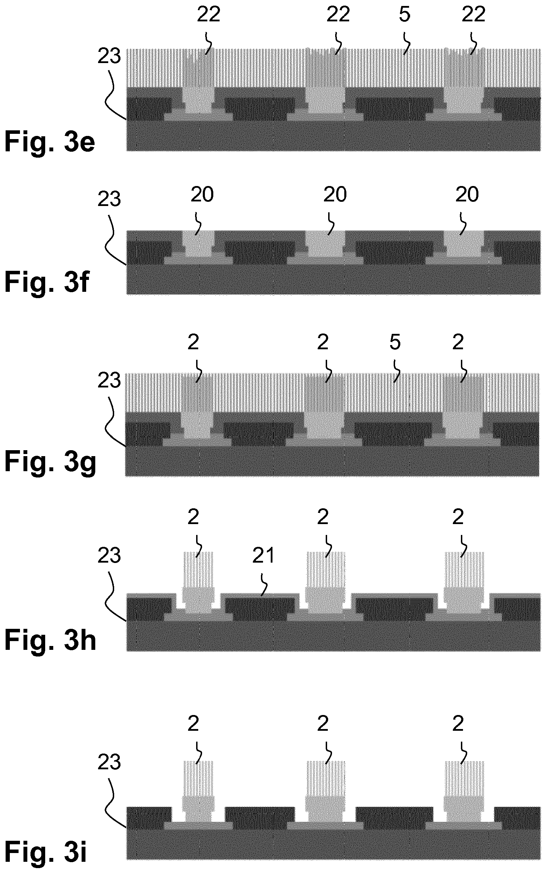

In Fig. 3e sind die hilfsweise gewachsenen Nanodrähte 22 zu erkennen, die in den Poren 8 der Folie 5 gewachsen worden sind. Die hilfsweise gewachsenen Nanodrähte 22 werden zusammen mit der Folie 5 entfernt.

In Fig. 3f ist die Situation nach Entfernen der Folie 5 mit den hilfsweise gewachsenen Nanodrähten 22 gezeigt. Es bleiben elektrisch leitende Bumps 20 übrig. Anschließend wird eine weitere Folie 5 auf die Strukturierungsschicht 4 aufgelegt und Nanodrähte 2 werden gewachsen. Die dabei erhaltenen Nanodrähte 2 sind die Nanodrähte, die nach Abschluss des Verfahrens auf den elektrisch leitenden Bereichen 19 (bzw. auf den Bumps 20) verbleiben und auf deren Wachstum das Verfahren gerichtet ist.

Fig. 3g zeigt die Nanodrähte 2 mit der Folie 5. Nach Wachstum dieser Nanodrähte 2 kann die Folie 5 entfernt werden, was zu der Darstellung von Fig. 3h führt, bei der durch einen chemischen Prozess neben der Folie 5 auch schon die Strukturierungsschicht 4 entfernt wurde. Schließlich wird die elektrisch leitende Elektrodenschicht 21 entfernt. Damit verbleiben, wie in Fig. 3i gezeigt, nur die Nanodrähte 2 und die Bumps 20 auf den elektrisch leitenden Bereichen 19 der Grundoberfläche 23.

### Bezugszeichenliste

- 1: Anordnung
- 2: Nanodraht
- 3: Oberfläche
- 4: Strukturierungsschicht
- 5: Folie
- 6: Mittel zum Bereitstellen eines Elektrolyten
- 7: Auslassung
- 8: Pore
- 9: Feder
- 10: Schwamm
- 11: Spannungsquelle / Stromquelle
- 12: Elektrode (Gegenelektrode)
- 13: Referenzelektrode
- 14: Messgerät
- 15: Kabel
- 16: Rohr
- 17: Heizung
- 18: Körper
- 19: elektrisch leitender Bereich
- 20: elektrisch leitender Bump
- 21: elektrisch leitende Elektrodenschicht
- 22: hilfsweise gewachsene Nanodrähte
- 23: Grundoberfläche
- 24: Grundstrukturierungsschicht

## Patentansprüche

1. Verfahren zum Bereitstellen einer Vielzahl von Nanodrähten (2), wobei das Verfahren zumindest die folgenden Verfahrensschritte umfasst:
a) Auflegen einer Folie (5) auf eine Oberfläche (3), wobei die Folie (5) eine Vielzahl von durchgehenden Poren (8) aufweist, in denen die Nanodrähte (2) gewachsen werden können,
b) Auflegen eines Mittels zum Bereitstellen eines Elektrolyten (6) auf die Folie (5), und
c) galvanisches Wachsen der Vielzahl von Nanodrähten (2) aus dem Elektrolyten,
**gekennzeichnet dadurch, dass** der Elektrolyt über ein Rohr dem Mittel zum Bereitstellen des Elektrolyten (6) entsprechend des Verbrauchs durch die galvanische Abscheidung zugeführt wird.

2. Verfahren nach Anspruch 1, wobei eine Strukturierungsschicht (4) zwischen der Oberfläche (3) und der Folie (5) bereitgestellt wird, wobei die Strukturierungsschicht (4) mindestens eine Auslassung (7) aufweist an einer Stelle der Oberfläche (3), an der die Nanodrähte (2) auf die Oberfläche (3) gewachsen werden sollen.

3. Verfahren nach einem der vorherigen Ansprüche, wobei das Verfahren zumindest teilweise unter Erwärmung stattfindet.

4. Verfahren nach einem der vorherigen Ansprüche, wobei das Mittel zum Bereitstellen des Elektrolyten (6) zumindest zeitweise an die Folie (5) gepresst wird.

5. Verfahren nach einem der vorherigen Ansprüche, wobei das Mittel zum Bereitstellen des Elektrolyten (6) schwammartig ausgeführt ist.

6. Verfahren nach einem der vorherigen Ansprüche, wobei die durchgehenden Poren (8) der Folie senkrecht zu der Oberfläche (3) ausgeführt sind.

7. Verfahren nach einem der vorherigen Ansprüche, wobei zum galvanischen Wachsen der Vielzahl von Nanodrähten (2) eine Spannung zwischen der zu bewachsenden Oberfläche (3) und einer an dem Mittel zum Bereitstellen des Elektrolyten (6) anliegenden Elektrode (12) angelegt wird.

8. Verfahren nach einem der vorherigen Ansprüche, weiterhin umfassend die Verfahrensschritte:
d) Entfernen der Folie (5) von der Oberfläche (3) einschließlich der in der Folie eingeschlossenen Vielzahl der Nanodrähte (2), und
e) Aufbringen der Folie (5) auf eine Zieloberfläche, wobei die in der Folie (5) eingeschlossene Vielzahl der Nanodrähte (2) mit der Zieloberfläche verbunden wird.

9. Verfahren nach einem der vorherigen Ansprüche, wobei die Folie (5) zumindest teilweise aufgelöst wird.

10. Verfahren nach einem der Ansprüche 2 bis 7, wobei die Oberfläche (3) eine Mehrzahl von elektrisch leitenden Bereichen (19) aufweist, wobei vor Schritt a) die folgenden Verfahrensschritte durchgeführt werden:
i) Aufbringen einer elektrisch leitenden Haftschicht auf die Oberfläche (3),
ii) Aufbringen einer elektrisch leitenden Elektrodenschicht (2) auf die Haftschicht,
iii) Aufbringen einer elektrisch isolierenden Strukturierungsschicht (4) auf die elektrisch leitende Elektrodenschicht (21), und
iv) Freilegen der elektrisch leitenden Bereiche (19) der Oberfläche (3) an den Stellen, an denen die Nanodrähte (2) auf die elektrisch leitenden Bereiche (19) gewachsen werden sollen, wobei eine elektrisch leitende Verbindung zwischen den elektrisch leitenden Bereichen (19) und der elektrisch leitenden Elektrodenschicht (21) erhalten bleibt,
wobei nach Schritt c) die folgenden Verfahrensschritte durchgeführt werden:
α) Entfernen der Folie (5),
β) Entfernen der Strukturierungsschicht (4),
γ) Entfernen der Elektrodenschicht (21), und
Δ) Entfernen der elektrisch leitenden Haftschicht.

11. Verfahren nach Anspruch 10, wobei die Folie (5) nach Durchführung der Schritte a) bis c) einschließlich der gewachsenen Nanodrähte (2) entfernt wird, wobei anschließend die Schritte a) bis c) erneut durchgeführt werden, und wobei die Schritte α) bis γ) nach der erneuten Durchführung der Schritte a) bis c) durchgeführt werden.

12. Verfahren nach Anspruch 11, wobei nach Abschluss des Wachstums der Vielzahl der Nanodrähte (2) eine Oxidschicht auf den Nanodrähten (2) zumindest teilweise entfernt wird.

13. Verfahren nach einem der vorherigen Ansprüche zur elektrischen Kontaktierung oder zur thermischen Verbindung einer LED auf einem Trägersubstrat.

14. Anordnung (1) zum Bereitstellen einer Vielzahl von Nanodrähten (2), umfassend zumindest:
- eine Oberfläche (3), auf die die Nanodrähte (2) gewachsen werden sollen,
- eine auf die Oberfläche (3) aufgelegte Folie (5), wobei die Folie (5) eine Vielzahl von durchgehenden Poren (8) aufweist, in denen die Nanodrähte (2) gewachsen werden können,
- ein auf die Folie (5) aufgelegtes Mittel zum Bereitstellen eines Elektrolyten (6), und
- mindestens eine Elektrode (12) zum galvanischen Wachsen der Vielzahl von Nanodrähten (2) aus dem Elektrolyten,
**gekennzeichnet dadurch, dass**
die Anordnung des Weiteren
- ein Rohr zum Zuführen des Elektrolyten an das Mittel zum Bereitstellen des Elektrolyten entsprechend des Verbrauchs durch die galvanische Abscheidung umfasst.

15. Anordnung nach Anspruch 14, weiterhin umfassend eine zwischen der Oberfläche (3) und der Folie (5) angeordnete Strukturierungsschicht (4), wobei die Strukturierungsschicht (4) mindestens eine Auslassung (7) aufweist an einer Stelle der Oberfläche (3), an der die Nanodrähte (2) auf die Oberfläche (3) gewachsen werden sollen.

16. Anordnung (1) nach Anspruch 14 oder 15 weiterhin umfassend eine Vorrichtung zum Bereitstellen der Strukturierungsschicht (4) auf der Oberfläche (3), auf die die Nanodrähte (2) gewachsen werden sollen.

17. Anordnung (1) nach einem der Ansprüche 14 bis 16 weiterhin umfassend eine Referenzelektrode (13).

## Claims

1. Method for providing a multiplicity of nanowires (2), wherein the method comprises at least the following method steps:
a) laying a film (5) onto a surface (3), wherein the film (5) has a multiplicity of through-extending pores (8) in which the nanowires (2) can be grown,
b) laying a means for providing an electrolyte (6) onto the film (5), and
c) galvanically growing the multiplicity of nanowires (2) from the electrolyte, **characterized in that** the electrolyte is fed via a pipe to the means for providing the electrolyte (6) in a manner corresponding to the consumption by the galvanic deposition.

2. Method according to Claim 1, wherein a structuring layer (4) is provided between the surface (3) and the film (5), wherein the structuring layer (4) has at least one aperture (7) at a location of the surface (3) at which the nanowires (2) are to be grown on the surface (3).

3. Method according to either of the preceding claims, wherein the method is performed at least partially with heating.

4. Method according to any of the preceding claims, wherein the means for providing the electrolyte (6) is at least intermittently pressed against the film (5).

5. Method according to any of the preceding claims, wherein the means for providing the electrolyte (6) is formed in the manner of a sponge.

6. Method according to any of the preceding claims, wherein the through-extending pores (8) of the film are formed perpendicularly with respect to the surface (3).

7. Method according to any of the preceding claims, wherein, for the galvanic growth of the multiplicity of nanowires (2), a voltage is applied between the surface (3) to be covered with growth and an electrode (12) which lies against the means for providing the electrolyte (6).

8. Method according to any of the preceding claims, furthermore comprising the method steps:
d) removing the film (5) from the surface (3), including the multiplicity of nanowires (2) enclosed in the film, and
e) applying the film (5) to a target surface, wherein the multiplicity of nanowires (2) enclosed in the film (5) is connected to the target surface.

9. Method according to any of the preceding claims, wherein the film (5) is at least partially dissolved.

10. Method according to any of Claims 2 to 7, wherein the surface (3) has a multiplicity of electrically conductive regions (19), wherein, before step a), the following method steps are performed:
i) applying an electrically conductive adhesive layer to the surface (3),
ii) applying an electrically conductive electrode layer (2) to the adhesive layer,
iii) applying an electrically insulating structuring layer (4) to the electrically conductive electrode layer (21), and
iv) exposing the electrically conductive regions (19) of the surface (3) at the locations at which the nanowires (2) are to be grown on the electrically conductive regions (19), wherein an electrically conductive connection is maintained between the electrically conductive regions (19) and the electrically conductive electrode layer (21),
wherein, after step c), the following method steps are performed:
α) removing the film (5),
β) removing the structuring layer (4),
γ) removing the electrode layer (21), and
Δ) removing the electrically conductive adhesive layer.

11. Method according to Claim 10, wherein the film (5) including the grown nanowires (2) is removed after the steps a) to c) have been performed, wherein the steps a) to c) are subsequently performed again, and wherein the steps α) to γ) are performed after the steps a) to c) have been performed again.

12. Method according to Claim 11, wherein, after the completion of the growth of the multiplicity of nanowires (2), an oxide layer on the nanowires (2) is at least partially removed.

13. Method according to any of the preceding claims for the electrical contacting or thermal connection of an LED to a carrier substrate.

14. Arrangement (1) for providing a multiplicity of nanowires (2), comprising at least:
- a surface (3) on which the nanowires (2) are to be grown,
- a film (5) laid onto the surface (3), wherein the film (5) has a multiplicity of through-extending pores (8) in which the nanowires (2) can be grown,
- a means, laid onto the film (5), for providing an electrolyte (6), and
- at least one electrode (12) for galvanically growing the multiplicity of nanowires (2) from the electrolyte,
**characterized in that** the arrangement furthermore comprises
- a pipe for feeding the electrolyte to the means for providing the electrolyte in a manner corresponding to the consumption by the galvanic deposition.

15. Arrangement according to Claim 14, furthermore comprising a structuring layer (4) arranged between the surface (3) and the film (5), wherein the structuring layer (4) has at least one aperture (7) at a location of the surface (3) at which the nanowires (2) are to be grown on the surface (3).

16. Arrangement (1) according to Claim 14 or 15, furthermore comprising a device for providing the structuring layer (4) on the surface (3) on which the nanowires (2) are to be grown.

17. Arrangement (1) according to any of Claims 14 to 16, furthermore comprising a reference electrode (13).

## Revendications

1. Procédé de production d'un grand nombre de nano-fils métalliques (2), le procédé comprenant au moins les étapes suivantes :
a) placer un film (5) sur une surface (3), le film (5) comportant un grand nombre de pores traversants (8) dans lesquels les nano-fils métalliques (2) peuvent être développés,
b) placer un moyen de production d'un électrolyte (6) sur le film (5), et
c) effectuer un développement galvanique du grand nombre de nano-fils métalliques (2) à partir de l'électrolyte,
**caractérisé en ce que** l'électrolyte est amené par le biais d'un tube au moyen de production de l'électrolyte (6) en fonction de la consommation par le dépôt galvanique.

2. Procédé selon la revendication 1, une couche de structuration (4) étant prévue entre la surface (3) et le film (5), la couche de structuration (4) comportant au moins une lacune (7) à un emplacement de la surface (3) où les nano-fils métalliques (2) doivent être développés sur la surface (3).

3. Procédé selon l'une des revendications précédentes, le procédé étant mis en œuvre au moins partiellement avec chauffage.

4. Procédé selon l'une des revendications précédentes, le moyen de production de l'électrolyte (6) étant pressé contre le film (5) au moins temporairement.

5. Procédé selon l'une des revendications précédentes, le moyen de production de l'électrolyte (6) étant conçu comme une éponge.

6. Procédé selon l'une des revendications précédentes, les pores traversants (8) du film étant perpendiculaires à la surface (3).

7. Procédé selon l'une des revendications précédentes, afin d'effectuer le développement galvanique du grand nombre de nano-fils métalliques (2), une tension étant appliquée entre la surface (3) à développer et une électrode (12) adjacente au moyen de production de l'électrolyte (6).

8. Procédé selon l'une des revendications précédentes, comprenant en outre les étapes suivantes :
d) retirer le film (5) de la surface (3) y compris le grand nombre de nano-fils métalliques (2) enfermés dans le film, et
e) appliquer le film (5) sur une surface cible, le grand nombre de nano-fils métalliques (2) enfermés dans le film (5) étant relié à la surface cible.

9. Procédé selon l'une des revendications précédentes, le film (5) étant au moins partiellement dissous.

10. Procédé selon l'une des revendications 2 à 7, la surface (3) comportant une pluralité de zones électriquement conductrices (19), les étapes de procédé suivantes étant réalisées avant l'étape a) :
i) appliquer une couche adhésive électriquement conductrice sur la surface (3),
ii) appliquer une couche d'électrode électriquement conductrice (2) sur la couche adhésive,
iii) appliquer une couche de structuration électriquement isolante (4) sur la couche d'électrode électriquement conductrice (21), et
iv) dégager les zones électriquement conductrices (19) de la surface (3) aux emplacements où les nano-fils métalliques (2) doivent être développés sur les zones électriquement conductrices (19), une liaison électriquement conductrice restant maintenue entre les zones électriquement conductrices (19) et la couche d'électrode électriquement conductrice (21),
les étapes de procédé suivantes étant réalisées après l'étape c) :
α) enlever le film (5),
β) enlever la couche structurante (4),
γ) enlever la couche d'électrode (21), et
Δ) enlever la couche adhésive électriquement conductrice.

11. Procédé selon la revendication 10, le film (5) étant enlevé après avoir réalisé les étapes a) à c) y compris avec les nano-fils métalliques développés (2), les étapes a) à c) étant ensuite à nouveau réalisées, et les étapes α) à γ) étant réalisées après avoir réalisé à nouveau les étapes a) à c).

12. Procédé selon la revendication 11, une fois le développement du grand nombre de nano-fils métalliques (2) terminé, une couche d'oxyde sur les nano-fils métalliques (2) étant au moins partiellement enlevée.

13. Procédé selon l'une des revendications précédentes destiné à établir un contact électrique ou une liaison thermique entre une LED et un substrat porteur.

14. Ensemble (1) destiné à produire un grand nombre de nano-fils métalliques (2), ledit ensemble comprenant au moins :
- une surface (3) sur laquelle les nano-fils métalliques (2) doivent être développés,
- un film (5) placé sur la surface (3), le film (5) comportant un grand nombre de pores traversants (8) dans lesquels les nano-fils métalliques (2) peuvent être développés,
- un moyen destiné à produire un électrolyte (6) et placé sur le film (5), et
- au moins une électrode (12) destinée à effectuer un développement galvanique du grand nombre de nano-fils métalliques (2) à partir de l'électrolyte, **caractérisé en ce que** l'ensemble comprend en outre
- un tube destiné à amener l'électrolyte au moyen de production de l'électrolyte en fonction de la consommation par le dépôt galvanique.

15. Ensemble selon la revendication 14, comprenant en outre une couche de structuration (4) disposée entre la surface (3) et le film (5), la couche de structuration (4) comportant au moins une lacune (7) à un emplacement sur la surface (3) où les nano-fils métalliques (2) doivent être développés sur la surface (3).

16. Ensemble (1) selon la revendication 14 ou 15 comprenant en outre un dispositif de production de la couche de structuration (4) sur la surface (3) sur laquelle les nano-fils métalliques (2) doivent être développés.

17. Ensemble (1) selon l'une des revendications 14 à 16 comprenant en outre une électrode de référence (13).
